## Europäisches Patentamt
## European Patent Office
## Office européen des brevets

(19)

(11) Publication number: **0 031 240**
**B1**

(12)

# EUROPEAN PATENT SPECIFICATION

(45) Date of publication of patent specification: **30.04.86**

(51) Int. Cl.⁴: **H 01 L 23/52, H 01 L 25/10**

(21) Application number: **80304552.5**

(22) Date of filing: **17.12.80**

(54) An electrical component comprising semiconductor chips.

| | |
|---|---|
| (30) Priority: **18.12.79 JP 164510/79** | (73) Proprietor: **FUJITSU LIMITED**<br>**1015, Kamikodanaka Nakahara-ku**<br>**Kawasaki-shi Kanagawa 211 (JP)** |
| (43) Date of publication of application:<br>**01.07.81 Bulletin 81/26** | (72) Inventor: **Honda, Norio**<br>**21-4, Miyashita Kamiarakuda Machikitamachi**<br>**Aizuwakamatsu-shi Fukushima 965 (JP)** |
| (45) Publication of the grant of the patent:<br>**30.04.86 Bulletin 86/18** | |
| (84) Designated Contracting States:<br>**DE FR GB** | (74) Representative: **Sunderland, James Harry et al**<br>**HASELTINE LAKE & CO Hazlitt House 28**<br>**Southampton Buildings Chancery Lane**<br>**London WC2A 1AT (GB)** |
| (56) References cited:<br>**FR-A-2 295 570**<br>**GB-A-1 217 323** | |

Courier Press, Leamington Spa, England.

## Description

This invention relates to an alectrical component comprising semiconductor chips, and more specifically to an assembly comprising a mother board and a plurality of chip carriers mounted on the mother board.

In the field of electronic component packaging to which the present invention pertains, the chip carrier, which may be but is not necessarily a square leadless package for an integrated circuit (IC), is widely used for mounting directly on a so-called mother board having internal conductors therein. The chip carrier is replacing the dual in-line package because of various reasons: reduction in size; improved electrical performance; and lower material cost being predominant factors.

According to the present invention there is provided an electrical component comprising a mother board which includes conductors and on which mother board are mounted semiconductor chip-carriers, characterised in that at least some of said semiconductor chip-carriers are mounted on the mother board via first and second unit boards each including conductors and extending across a respective portion of the mother board, said conductors both of the mother board and of the unit boards providing electrical connections for the or each respective item mounted thereon, wherein the or each first unit board has a plurality of said semiconductor chip-carriers directly mounted thereon, the or each second unit board has one or more first unit boards and/or one or more of said semiconductor chip-carriers directly mounted thereon, and the mother board has a plurality of second unit boards directly mounted thereon.

Preferred embodiments or of the present invention may be designed with features intended specifically to achieve various objects.

It may therefore be a primary object of such an embodiment to simplify multi-layer internal conductors within the mother board, which may be fabricated in the form of a multi-layer-conductor substrate.

It may be another object of such an embodiment to improve the product yield in the manufacture and assembly of an electrical component comprising a mother board and a number of chip carriers.

Another possible object of a preferred embodiment of the invention may be to provide a mother board/chip carrier assembly which is capable of accommodating changes of circuit arrangement or arrangement of chip carriers.

It may be yet another object of a preferred embodiment of the invention to offer a mother board/chip carrier assembly in which voltage drop and/or signal attenuation are lessened, thereby improving the characteristic impedance of the mother board.

The above and further objects and novel features of preferred embodiments of the invention will appear more fully from the following detailed description when read in connection with the accompanying drawings. It is to be expressly understood, however, that the drawings are not intended as a definition of the invention, but are for the purpose of illustration only of preferred embodiments.

For a better understanding of the invention and to show how it may be put into effect reference will now be made, by way of example, to the accompanying drawings in which:

Fig. 1 is a cross-sectional side view of a conventional assembly of a mother board and chip carriers mounted thereon;

Fig. 2 is a plan view of the mother board and chip carrier assembly of Fig. 1;

Fig. 3 is a side view partly in cross-section of a mother board and chip carrier assembly which is in accordance with the invention;

Fig. 4 is a perspective view of a ceramic unit board of Fig. 3 on which chip carriers are directly mounted;

Fig. 5 is a plan view of another embodiment of a mother board and chip carrier assembly which is in accordance with the invention; and

Fig. 6 is a side view of a major portion of the assembly of Fig. 5.

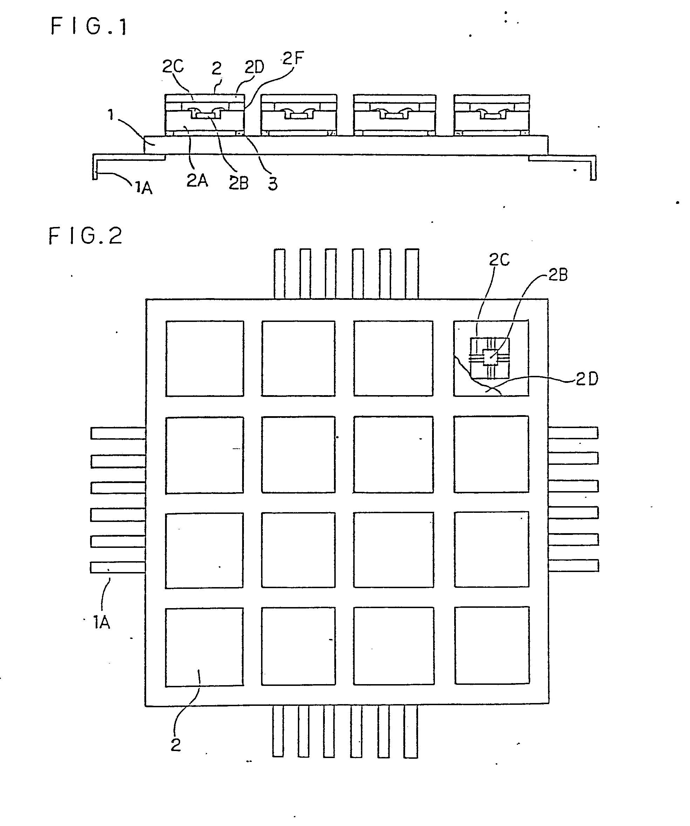

A typical known manner of mounting chip carriers is illustrated in Fig. 1, in which a ceramic multi-layer-conductor substrate or so-called mother board 1 is shown with chip carriers directly mounted thereon. An exemplary chip carrier 2 comprises a main body 2A covered by a cap or lid 2D, and a semiconductor chip 2B within the chip carrier is connected by bonding or connecting wires 2C to conductor patterns 2F. The chip carrier 2 is connected to the mother board 1 by solders 3, and the mother board 1 may itself be mounted in a printed circuit board, not shown, by lead or terminal pins 1A. Fig. 1 has been prepared for the purpose of illustrating how chip carriers are typically mounted on a mother board. However, in practical applications each chip carrier is mounted upside down, with a conventional heat sink of cylindrical configuration being provided on the chip carrier.

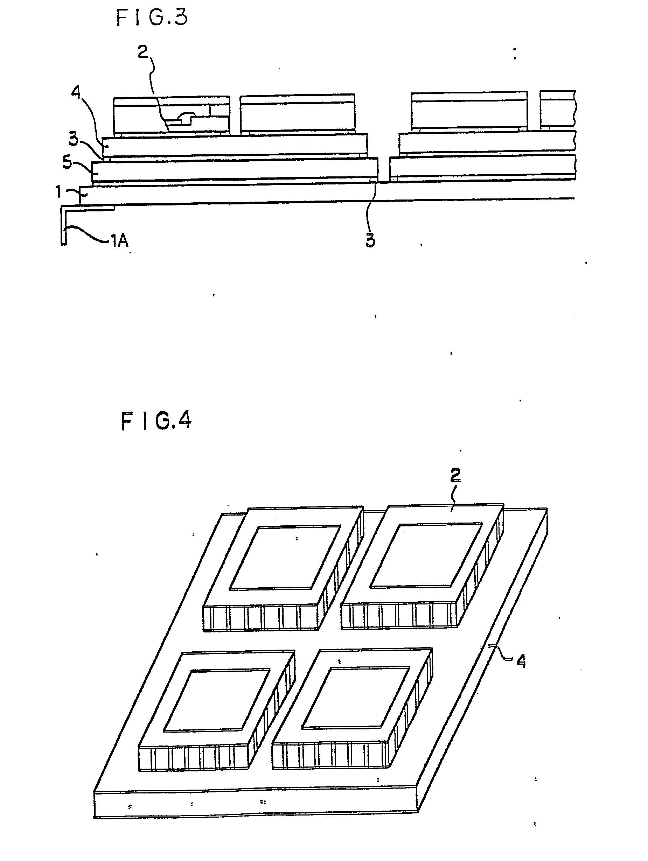

Employing the type of assembly shown in Fig. 1, the recent trend in the industry has been to mount several hundred chip carriers such as carrier 2 on a single mother board in a matrix array, for example as seen in a simplified plan view, for only sixteen chip carriers, in Fig. 2. In such a case employing several hundred chip carriers, internal multi-layer conductors inside the mother board are bound to become long and complex, tending to lower the product yield, i.e. the percentage of acceptable components produced in a batch of such components. In addition where there is a need for a new assembly, of the mother board and chip carriers, which is different from a standardized assembly only in some part of the circuit, it has often been experienced that a standard mother board is utterly useless. Furthermore, multi-layer internal conductors which are fabricated in the mother board have high value resistance, and cause voltage drop and/or signal attenuation.

These conductors are made, as is known to the person skilled in the art, by sintering together with the ceramic board 1, so that these conductors must be made of material which is resistive to high temperature. Suitable material for such conductors is usually selected from the group of metals comprising tungsten, molybdenum and the like. Although these are metallic materials, their electrical resistance is approximately five times higher than that of gold, silver or copper. In order to fabricate the conductors in the form of thin film, paste containing pulverized metal material is coated on green ceramic sheet and then the green sheet is fired. Thus, the value of resistance of the conductor so produced is usually twice as high as that of the plated conductor. It has been found that internal multi-layer conductors as a whole have considerably high-value resistance for the above-described reason. Where these conductors are used for connection to a power source for example, the voltage drop is substantial, and a considerable amount of heat is emitted. Such a weakness is experienced more severely where the overall length of the conductor is large, which will be the case with recent technology developed to increase the packing density.

Where these conductors are used as signal transmission lines, signal attenuation has been noted, although the attenuation is not so remarkable as is the voltage drop in conductors connecting to a power source.

In the transmission of signals, there is another characteristic that must be taken into consideration, that is the dielectric constant of the material surrounding the conductive path. The velocity of a given signal is inversely proportional to the square root of the dielectric constant of the material covering the signal path. If the conductor is buried within a ceramic substrate comprising alumina, the dielectric constant of which is in the order of 9 to 10, the velocity of the signal transmitted through such a conductor is approximately one third the velocity of the same signal passing through a conductor exposed to air, it being understood that the dielectric constant of air is 1. If all the conductors are fabricated as internal conductors within a ceramic substrate, it will be apparent that there is very little room for improving the characteristic impedance of the conductors and the velocity of the signals transmitted through these conductors.

An electrical component comprising semiconductor chips which is in accordance with the invention is shown in side view, partly in cross-section, in Fig. 3. The component comprises an assembly of a mother board and chip carriers utilizing ceramic unit boards, as will be described hereinafter in detail. Thus, in this embodiment of the invention, four conventional ceramic chip carriers 2 are mounted on an exemplary first ceramic unit board 4 by solders, as seen also in the perspective view of Fig. 4. Several of these first unit boards 4 are mounted on each second ceramic unit board 5 by terminal or lead bumps, or solders, 3 provided on each board 4 as seen in Fig. 3. Several of these second unit boards 5 are mounted on a mother board 1 which is to be mounted in a printed circuit board, not shown, by terminal pins 1A, only one of which is shown in Fig. 3. As was explained with respect to chip carrier 2 in Fig. 1, the chip carriers 2 are shown in Fig. 3 in a manner inverse to actual application. That is, the chip carriers are mounted upside-down in actual applications. The first and second unit boards 4 and 5 are manufactured in a similar manner to the mother board 1 using conventional technique.

It will thus be understood by those skilled in the art that, in the assembly just described, the mother board 1 is in effect partitioned into several predetermined sub-sections or portions on each of which a second unit board 5 is mounted. Some chip carriers 2 may be directly mounted on the mother board 1 if required. This arrangement may be modified to accommodate the needs of the users as will be described hereinafter.

In the component or assembly shown in Figs. 3 and 4, the first and second unit boards 4 and 5 have multi-layer internal conductors fabricated therein according to conventional technique. Although not depicted in these figures, these unit boards 4 and 5 also have on their upper and lower (as seen in the drawing) surfaces a number of external conductors which are plated thereon according to known art, for example gold on nickel. The upper surface of the mother board 1 may also be formed with external conductors.

By means of this arrangement, part of the conductors which have previously been formed internally within the mother board 1, may be replaced not only by internal conductors fabricated within unit boards 4 and 5, but also by plated conductors formed on the upper and lower surfaces of the unit boards 4 and 5 as well as on the surfaces (particularly the upper surface) of the mother board 1 itself. As will be understood from Fig. 3, the unit board 5 defines a considerable space above the mother board 1, which space is exposed to air. Therefore, it is possible to form external conductors on that part of the surface of the mother board 1 which is thus exposed to air. This reduces substantially the conductors which must be fabricated internally within the body of the mother board 1, which in turn serves the purpose of improving the manufacturing yield of the mother board.

In the actual process of assembly of the chip carriers 2 onto the mother board 1, a plurality of chip carriers 2 are mounted on the first unit board 4, using conventional technique. After assembly of the chip carriers 2 onto the first unit board 4, these are tested in known manner. Satisfactory assemblies of unit boards 4 and chip carriers 2 are selected to be mounted to the second unit boards 5. Assemblies of second unit boards 5 and first unit boards 4 are likewise tested according to conventional technique, and only good assemblies of unit boards 5 and 4 are mounted on the mother board 1, which also has been tested in the same fashion. It will thus be understood by those skilled in the art that the product yield in the preparation of the mother board 1 and chip carrier assembly as shown in Figs. 3 and 4 may be remarkably improved.

Where a new assembly of mother board 1 and chip carriers 2 is desired wherein only a part of the circuit need be changed as compared with a conventional assembly, such a change can be accommodated by merely changing one or some of the unit boards 4 and 5, without changing other unit boards and the mother board 1. This will make it possible to accommodate a new requirement without necessitating change of the mother board 1. This will expand the field of application of existing mother boards at the improved rate of product yield.

In addition, where external conductors fabricated on the upper and lower surfaces of unit boards 4 and 5 and the upper surface of the mother board 1 are used as conductors for connecting to power sources, voltage drop may substantially be lessened by plating in known manner conductors which are longer than other conductors. Thus, heat generated by such conductors can be decreased.

Furthermore, where these external conductors are used as signal paths, signal attenuation is lessened. In addition, since these conductors are exposed to outside air of which the dielectric constant is 1, the signal is transmitted three times as fast as compared with conductors surrounded by alumina, the dielectric constant of which is in the order of 9 to 10. The reason for this is that, as explained before, the velocity of the signal is inversely proportional to the square root of the dielectric constant of the material surrounding the signal path.

It will further be understood by those skilled in the art that formation and change of the circuit of an assembly such as shown in Figs. 3 and 4 can be carried out in several ways by varying the arrangemeent of chip carriers 2 and unit boards 4 and 5. For example, chip carriers 2 may also be mounted directly on a second unit board 5 and/or on the mother board 1. The combination of chip carriers 2, first unit boards 4, second unit boards 5, and the mother board 1, may be varied in order to meet requirements from users for new circuit arrangements.

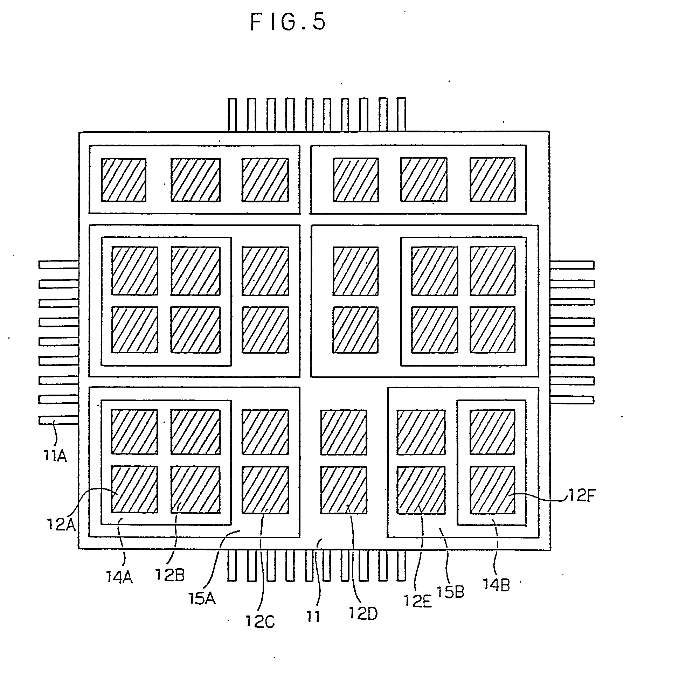

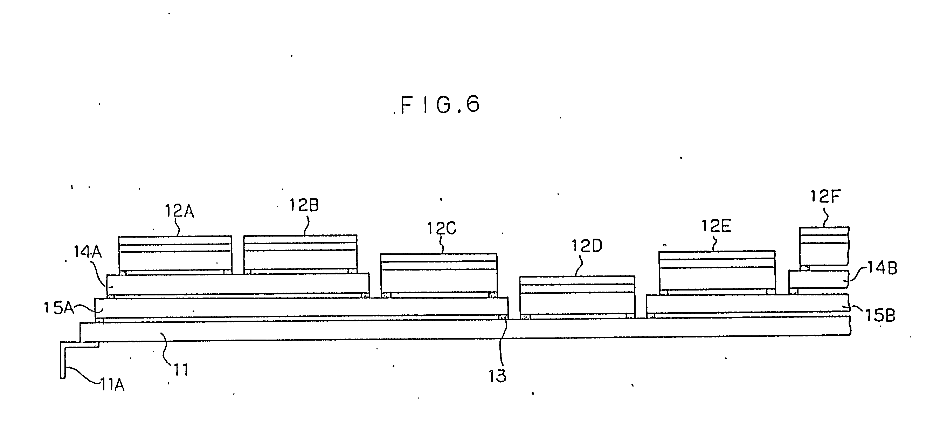

Figs. 5 and 6 show another embodiment of the invention, in plan view and in side view with a small portion cut-off, respectively. In this embodiment, there is a mother board or ceramic multilayer-conductor substrate 11 which is partitioned into portions in the same manner as the mother board of Fig. 3, by use of unit boards. 11A is a terminal pin similar to terminal pin 1A of Fig. 3 which, together with similar terminal pins, connects the mother board 11 to a printed circuit board, not shown. Ceramic chip carriers 12A, 12B, 12C, etc. are similar to the chip carriers 2 of Fig. 3. Lead bumps or solders 13 connect second unit boards to the mother board in a similar manner as do the solders 3 of the Fig. 3 embodiment. These are all conventional. First unit boards 14A, 14B, 14C, etc. are similar to the first unit boards 4 of Fig. 3, and second unit boards 15A, 15B, 15C, etc. are similar to the second unit boards 5 of Fig. 3. In Fig. 6 the second unit boards are seen to extend across relatively large predetermined respective portions of the mother board and are directly mounted thereon, whereas the first unit boards are seen to extend across smaller respective portions of the mother board, and are indirectly mounted thereon via the second unit boards.

In this embodiment of Figs. 5 and 6, ceramic chip carriers 12A and 12B are mounted directly on the first unit board 14A in a manner similar to that shown in Fig. 4. Ceramic chip carrier 12C is mounted directly on the second unit board 15A. Ceramic chip carrier 12D is mounted directly on the mother board 11. Ceramic chip carrier 12E is mounted directly on the second unit board 15B. Ceramic chip carrier 12F is mounted directly on the first unit board 14B. The first unit board 14A is mounted directly on the second unit board 15A by lead bumps or solders provided on the first unit board 14A, and the second unit board 15A is mounted directly on the mother board 11 by lead bumps or solders 13 provided on the second unit board 15A. This arrangement indicates to those skilled in the art that selection of a desired structure of the assembly of chip carriers and the mother board can be obtained from a great number of combinations of the chip carriers, the first and second unit boards and the mother board.

It will be understood from the foregoing description that a characteristic feature of the embodiments resides in the fact that a unit board carrying a minimum number of required chip carriers is mounted on the mother board or ceramic multi-layer-conductor substrate either directly or via another unit board which is larger than the first-mentioned unit board. These unit boards comprise conductors which may be plated on their upper and lower surfaces, and the mother board may have similar conductors fabricated on its surfaces, particularly on its upper surface. Thus, conductors which have hitherto been formed internally of the mother board substrate may be replaced by conductors fabricated on and within the unit.

The product yield in the manufacture of the mother board and in the assembly of chip carriers and the mother board using the unit boards may be increased: adaptability to circuit change may be enhanced; electric characteristics may be improved due to decrease of voltage drop in conductors; heat generated in the assembly may be lessened; and matching of charactersitic impedance may be improved.

It should be understood that, although two kinds of unit boards are described and shown in and in connection with the foregoing description of preferred embodiments of the invention, in other embodiments more unit boards of different size may be used.

## Claims

1. An electrical component comprising a mother board (1; 11) which includes conductors and on which mother board are mounted semiconductor chip-carriers (2; 12A to 12F), characterised in that at least some of said semiconductor chip-carriers are mounted on the mother board via first (4; 14A; 14B) and second (5; 15A, 15B) unit boards each including conductors and extending across a respective portion of the mother board, said conductors both of the mother board and of the unit boards providing electrical connections for the or each respective item mounted thereon, wherein the or each first unit board (4; 14A; 14B) has a plurality of said semiconductor chip-carriers directly mounted thereon, the or each second unit board (5; 15A, 15B) has one or more first unit boards and/or one or more of said semiconductor-chip carriers directly mounted thereon, and the mother board has a plurality of second unit boards directly mounted thereon.

2. An electrical component according to claim 1, wherein said mother board (1; 11) and/or said semiconductor-chip carriers (2; 12A to 12F) and/or said unit boards (4, 5; 14A, 14B, 15A, 15B) comprise ceramic material.

3. An electrical component according to claim 1 or 2, wherein said mother board (1; 11) comprises terminal pins (1A; 11A) adapted to allow the mother board to be mounted on and electrically connected to a printed circuit board.

4. An electrical component according to any one of the preceding claims, wherein each of said semiconductor-chip carriers (2; 12A to 12F) contains a semiconductor integrated chip (2B).

5. An electrical component according to any one of the preceding claims, wherein one or more semiconductor-chip carriers (12C, 12E) are also mounted directly on one or more second unit boards (15A, 15B).

6. An electrical component according to any one of the preceding claims, wherein the or each of said unit boards (4, 5; 14A, 14B, 15A, 15B) is mounted such that there is space between it and the unit board (5, 15A, 15B) or mother board (1, 11) on which it is mounted.

7. An electrical component according to claim 6, wherein the or each of said unit boards (2; 12A to 12F) comprises terminal bumps (3) whereby the unit board is mounted.

8. An electrical component according to any one of the preceding claims, wherein the or each of said unit boards (4, 5; 14A, 14B, 15A, 15B) is formed with both internal conductors and external conductors.

9. An electrical component according to any one of the preceding claims, wherein a surface of said mother board (1, 11) is provided with external conductors.

10. An electrical component according to claim 8 or 9, wherein said external conductors of said unit boards (4, 5; 14A, 14B, 15A, 15B) and/or mother board (1, 11) are plated.

11. An electrical component according to any one of the preceding claims, wherein one or more than one semiconductor-chip carrier (12D) is mounted directly on said mother board (11).

## Revendications

1. Composant électrique comprenant une plaquette mère (1; 11) qui comporte des conducteurs et sur laquelle plaquette mère sont montés des supports de puces semiconductrices (2; 12A à 12F), caractérisé en ce qu'au moins certains desdits supports de puces semiconductrices sont montés sur la plaquette mère par l'intermédiaire de premières plaquettes unitaires (4; 14A, 14B) et de deuxièmes plaquettes unitaires (5; 15A, 15B) comportant chacune des conducteurs et s'étendant transversalement sur une partie respective de la plaquette mère, lesdits conducteurs de la plaquette mère et des plaquettes unitaires fournissant des connexions électriques à l'article ou à chacun des articles respectifs qui y sont montés, où sur la première plaquette unitaire ou chaque première plaquette unitaire (4; 14A, 14B) sont directement montés plusieurs supports de puces semiconductrices, sur la deuxième plaquette unitaire au chaque deuxième plaquette unitaire (5; 15A, 15B) sont directement montées une ou plusieurs premières plaquettes unitaires et, ou bien, un ou plusieurs desdits supports de puces semiconductrices, et sur la plaquette mère sont directement montées plusieurs deuxièmes plaquettes unitaires.

2. Composant électrique selon la revendication 1, où ladite plaquette mère (1; 11) et, ou bien, lesdits supports de puces semiconductrices (2; 12A à 12F) et, ou bien, lesdites plaquettes unitaires (4, 5; 14A, 14B, 15A, 15B) sont constitués en céramique.

3. Composant électrique selon la revendication 1 ou 2, où ladite plaquette mère (1; 11) comprend des broches de bornes (1A; 11A) destinées à permettre dé monter la plaquette mère sur une plaquette de circuit imprimé et de la connecter électriquement avec celle-ci.

4. Composant électrique selon l'une quelconque des revendications précédentes, où chacun desdits supports de puces semiconductrices (2; 12A à 12F) contient une puce intégrée semiconductrice (2B).

5. Composant électrique selon l'une quelconque des revendications précédentes, où un ou plusieurs supports de puces semiconductrices (12C, 12E) sont également montés directement sur une ou plusieurs deuxièmes plaquettes unitaires (15A, 15B).

6. Composant électrique selon l'une quelconque des revendications précédentes, où la plaquette unitaire ou chaque plaquette unitaire (4, 5; 14A, 14B, 15A, 15B) est montée de telle manière qu'il existe un espace entre elle et la plaquette unitaire (5, 15A, 15B) ou la plaquette mère (1, 11) sur laquelle elle est montée.

7. Composant électrique selon la revendication 6, où la plaquette unitaire ou chaque plaquette unitaire (2; 12A à 12F) comprend des surépais- seurs (3) de bornes par l'intermédiaire desquelles la plaquette unitaire est montée.

8. Composant électrique selon l'une quelconque des revendications précédentes, où la plaquette unitaire ou chaque plaquette unitaire (4, 5; 14A, 14B, 15A, 15B) est dotée à la fois de conducteurs internes et de conducteurs externes.

9. Composant électrique selon l'une quelconque des revendications précédentes, où une surface de ladite plaquette mère (1, 11) est dotée de conducteurs externes.

10. Composant électrique selon la revendication 8 ou 9, où lesdits conducteurs externes desdites plaquettes unitaires (4, 5; 14A, 14B, 15B) et, ou bien, de la plaquette mère (1, 11) sont plaqués.

11. Composant électrique selon l'une quelconque des revendications précédentes, où un ou plus d'un support de puces semiconductrices (12D) sont montés directement sur ladite plaquette mère (11).

**Patentansprüche**

1. Elektrisches Bauelement mit einer Mutterplatte (1; 11), welche Leiter enthält und auf welcher Halbleiterchipträger (2; 12A bis 12F) angeordnet sind, dadurch gekennzeichnet, daß wenigstens einige der genannten Halbleiterchipträger auf der Mutterplatte über erste (4; 14A, 14B) und zweite (5; 15A, 15B) Einheitsplatten angeordnet sind, welche jeweils Leiter enthalten und sich quer über einen entsprechenden Abschnitt der Mutterplatten erstrecken, die Leiter sowohl der Mutterplatten als auch der Einheitsplatten elektrische Verbindungen für das oder jedes darauf angeordnete Teil enthalten, wobei auf jeder ersten Einheitsplatte (4; 14A; 14B) eine Anzahl der genannten Halbleiterchipträger direkt montiert ist, auf der oder jeder zweiten Einheitsplatte (5; 15A, 15B) ein oder mehrere erste Einheitsplatten und/oder ein oder mehrere der genannten Halbleiterchipträger direkt montiert sind und auf der Mutterplatte eine Vielzahl der zweiten Einheitsplatten direkt angeordnet ist.

2. Elektrisches Bauelement nach Anspruch 1, bei welchem die genannte Mutterplatte (1; 11) und/oder die genannten Halbleiterchipträger (2; 12A bis 12F) und/oder die Einheitsplatten (4, 5; 14A, 14B, 15A, 15B) keramisches Material umfassen.

3. Elektrisches Bauelement nach Anspruch 1 oder 2, bei welchem die genannte Mutterplatte (1; 11) Anschlußstifte (1A; 11A) umfaßt, die adaptiert sind, um zu erlauben, daß die Mutterplatte auf einer gedruckten Schaltungsplatte angeordnet und elektrisch mit dieser verbunden wird.

4. Elektrisches Bauelement nach einem der vorhergehenden Ansprüche, bei welchem jeder der Halbleiterchipträger (2; 12A bis 12F) ein integriertes Halbleiterchip (2B) enthält.

5. Elektrisches Bauelement nach einem der vorhergehenden Ansprüche, bei welchem ein oder mehrere Halbleiterchipträger (12C, 12E) ebenfalls direkt auf einer oder mehreren zweiten Einheitsplatten (15A, 15B) angeordnet sind.

6. Elektrisches Bauelement nach einem der vorhergehenden Ansprüche, bei welchem die oder jede der genannten Einheitsplatten (4, 5; 14A, 14B, 15a, 15B) so angeordnet ist, daß es einen Abstand zwischen ihr und der Einheitsplatte (5, 15A, 15B) oder der Mutterplatte (1, 11), auf welcher sie angeordnet ist, gibt.

7. Elektrisches Bauelement nach Anspruch 6, bei welchem die oder jede Einheitsplatte (2; 12A bis 12F) Anschlußstöße (3) umfaßt, wodurch die Einheitsplatte montiert ist.

8. Elektrisches Bauelement nach einem der vorhergehenden Ansprüche, bei welchem die oder jede Einheitsplatte (4, 5; 14A, 14B, 15A, 15B) sowohl mit inneren Leitern als auch mit äußeren Leitern gebildet ist.

9. Elektrisches Bauelement nach einem der vorhergehenden Ansprüche, bei welchem die Oberfläche der genannten Mutterplatten (1, 11) externe Leiter aufweist.

10. Elektrisches Bauelement nach Anspruch 8 oder 9, bei welchem die genannten externen Leiter der genannten Einheitsplatten (4, 5; 14A, 14B, 15A, 15B) und/oder die Mutterplatten (1, 11) plattiert sind.

11. Elektrisches Bauelement nach einem der vorhergehenden Ansprüche, bei welchem ein oder mehrere Halbleiterchipträger (12D) direkt auf der genannten Mutterplatte (11) montiert sind.

**0 031 240**

F I G . 1

F I G . 2

1

F I G.3

F I G.4

FIG.5

FIG.6